# EUROPÄISCHE PATENTSCHRIFT

(11) **EP 3 721 514 B1**
(45) Veröffentlichungstag und Bekanntmachung des Hinweises auf die Patenterteilung: **27.11.2024**
(21) Anmeldenummer: 18811534.9
(22) Anmeldetag: 29.11.2018
(51) Int. Cl.: H02B 1/052, H01H 71/02, H02B 1/04, H02B 1/32

(54) **ADAPTER ZUR MONTAGE ELEKTROTECHNISCHER BAUTEILE**
ADAPTER FOR MOUNTING OF ELECTROTRECHNICAL COMPONENTS
ADAPTATEUR DE MONTAGE DE COMPOSANTS ÉLECTROTECHNIQUES

(30) Priorität: 08.12.2017 DE 102017129217
(43) Veröffentlichungstag der Anmeldung: 14.10.2020
(73) Patentinhaber: Eaton Intelligent Power Limited, Dublin 4 (IE)
(72) Erfinder: GERVING, Karsten, 53229 Bonn (DE); MOLITOR, Ute, 53474 Bad Neuenahr-Ahrweiler (DE)
(74) Vertreter: Epping - Hermann - Fischer
(86) Internationale Anmeldenummer: PCT/EP2018/082988
(87) Internationale Veröffentlichungsnummer: WO 2019/110414

(56) Entgegenhaltungen:
- EP-A1- 0 762 581
- WO-A1-2015/144265
- WO-A1-99/45556
- DE-A1- 19 627 295
- DE-A1- 19 748 531
- DE-A1- 19 836 762
- DE-B3- 102005 009 993
- DE-B4- 102012 016 094
- DE-U1- 202008 015 309
- DE-U1- 202016 103 379
- DE-U1- 29 508 611
- FR-A1- 2 447 132
- US-B1- 6 531 940

## Beschreibung

Die vorliegende Offenbarung betrifft einen Adapter zur Montage elektrotechnischer Bauteile.

Tragschienen sind metallische Profilschienen, an denen elektrotechnische Bauteile wie elektrische Schutzschalter, Relais und Klemmen in Verteilerkästen, Schaltschränken, Anschlusskästen und dergleichen befestigt werden. Ein Bauteil kann auf eine Tragschiene seitlich aufgeschoben oder von vorne aufgesteckt und festgeklemmt werden. Tragschienen können eine nach DIN EN 60715 genormte Form aufweisen (kurz DIN-Schiene). Ein Beispiel einer solchen DIN-Schiene ist die sogenannte Hutschiene gemäß DIN EN 60715 TH35, die ein U-förmiges, insbesondere Hut-förmiges Profil aufweist. Diese Hutschiene wird auch als DIN Rail bezeichnet. Für die Montage an einer Hutschiene müssen Bauteile speziell vorbereitet sein. In der Regel ist dies bei Bauteilen der Fall, die für eine Schaltschrankmontage vorgesehen sind.

Aus der deutschen Gebrauchsmusterschrift DE 295 08 611 U1 ist ein Universal-Motorschutzrelais mit einem Formgehäuse bekannt, bei dem vorderseitig durch Anformung eine Tragschiene integriert ist, so dass es auf einfache Weise mit einem elektromagnetischen Schaltgerät wie einem Schütz verbunden werden kann. Die deutsche Offenlegungsschrift DE 196 27 295 A1 offenbart einen Verstärkerbaustein, bei dem am Gehäuse vorderseitig ebenfalls eine Tragschiene angeformt ist, um daran beispielsweise ein Schütz befestigen zu können.

Aus der internationalen Patentanmeldung WO 2015/144265 A1 ist ein busfähiges aneinanderreihbares Anschluss- und/oder Funktionsmodul zur Steuerung und/oder Überwachung technischer Prozesse mit einem blockartigen Aufbau bekannt, das eine Basiseinheit zur Befestigung an einer Tragschiene aufweist.

Die deutsche Gebrauchsmusterschrift DE 20 2008 015309 U1 offenbart ein Montagesystem zur Montage elektrischer und/oder mechanischer Komponenten an einer Montagebasis, die wenigstens ein Montagebasisprofil bzw. wenigstens einen Montagebasiskörper aufweist.

Die deutsche Offenlegungsschrift DE 197 48 531 A1 beschreibt einen Verbraucherabzweig zum Schalten und Schützen eines in einem Hauptstromkreis für Spannungen über 100 Volt anschließbaren Verbrauchers, umfassend eine Abzweig-Baugruppe und ein Trägerteil mit ersten Steckanschlüssen zum Anschluß an einen Energiebus mit Hauptstromleitungen, an einen Datenbus und erforderlichenfalls an einen Hilfsenergie-Bus, wobei die Abzweig-Baugruppe auf dem Trägerteil mechanisch adaptierbar und über erste Gegensteckanschlüsse mit den ersten Steckanschlüssen kontaktierbar ist.

Die US-Patentschrift US 6 531 940 B1 beschreibt eine Kombination bestehend aus einem Schütz und einem Soft-Starter, der auf dem Schütz montiert ist.

Die europäische Patentanmeldung EP 0 762 581 A1 betrifft eine Vorrichtung zum Befestigen eines elektrischen Gerätes auf einem Adapter, wobei das elektrische Gerät mit einem auf eine hutförmige Tragschiene aufrasbaren Klemmfuss versehen und die Tragschiene auf dem Adapter verschieb- und verrastbar befestigt ist, um den Anschluss des elektrischen Gerätes an einem am Adapter fest angeordneten elektrischen Anschluss durch Verschieben der das Gerät zu tragen bestimmten Tragschiene in Anschlussrichtung des elektrischen Gerätes zu erleichtern.

Die deutsche Patentschrift DE 10 2005 009 993 B3 beschreibt einen Geräteadapter mit einem Basisteil, das auf seiner Unterseite mit Schienenaufnahmen zum Anbringen und Kontaktieren an Stromsammelschienen versehen ist und auf seiner Oberseite eine mit Verbindungsmitteln lösbar befestigte Aufbauvorrichtung mit zwei parallel voneinander beabstandeten Längsleisten zum Ankoppeln elektrischer Geräte oder Installationseinheiten trägt.

Die deutsche Offenlegungsschrift DE 198 36 762 A1 beschreibt einen Sammelschienen-Adapter mit wenigstens einer Tragschiene zum Aufsetzen und/oder Befestigen von Installationsgeräten oder dergleichen, der hinsichtlich eines einfachen Aufbaus, einer leichten Herstellung und einer leichten Verschiebung der Tragschiene bei sicherer Arretierung an der gewünschten Stelle verbessert ist.

Nachfolgend wird ein Adapter zur Montage elektrotechnischer Bauteile beschrieben. Gemäß einem ersten Aspekt wird ein Adapter zur Montage elektrotechnischer Bauteile offenbart, der in Form einer standardisierten Tragschiene, insbesondere Hutschiene, ausgebildet ist. An seiner Oberseite weist der Adapter Befestigungsmittel zur Montage eines elektrotechnischen Bauteils auf, und an seiner Unterseite weist er Befestigungsmittel zur Montage auf der Frontplatte eines elektrotechnischen Bauteils auf. Ein derartiger Adapter ermöglicht eine gestapelte Anordnung von elektrotechnischen Bauteilen wie beispielsweise Schaltgeräten, Schützen, Motorschutzschaltern oder dergleichen Bauteilen in beispielsweise einem Schaltschrank. Dadurch kann der in einem Schaltschrank vorhandene Platz im Vergleich zu einer Anordnung der Bauteile auf einer Tragschiene nebeneinander effizient genutzt werden.

Die Befestigungsmittel an der Unterseite des Adapters weisen mindestens einen Einrasthaken auf, der zum Einrasten in eine entsprechende Einrastöffnung auf der Frontplatte des elektrotechnischen Bauteils ausgebildet ist. Die Befestigungsmittel an der Unterseite des Adapters weisen zusätzlich mindestens einen Schnapphaken auf, der zum Einschnappen in eine entsprechende Einschnappöffnung auf der Frontplatte des elektrotechnischen Bauteils ausgebildet ist. Durch das Einrasten und Einschnappen kann ein Bauteil auf dem Adapter fixiert werden. Die Befestigungsmittel fixieren den Adapter auf der Frontplatte des elektrotechnischen Bauteils derart, dass der Adapter nicht auf der Frontplatte verrutschen kann.

In Implementierungen des Adapters kann mindestens ein Vorsprung auf der Oberseite des Adapters vorgesehen sein. Der mindestens eine Vorsprung kann insbesondere dazu vorgesehen sein, eine unbeabsichtigte Versetzung eines auf dem Adapter montierten Bauteils in der Montageebene zu verhindern.

In weiteren Implementierungen des Adapters können die Befestigungsmittel an der Unterseite des Adapters mindestens eine Schraube aufweisen, die in eine entsprechende Gewindeöffnung auf der Frontplatte eines elektrotechnischen Bauteils eingeschraubt werden kann.

In weiteren Implementierungen des Adapters können die Befestigungsmittel an der Oberseite des Adapters mindestens ein Gewinde aufweisen, in das eine an der Unterseite eines elektrotechnischen Bauteils vorgesehene Schraube eingeschraubt werden kann.

In Implementierungen des Adapters kann zumindest eines der Befestigungsmittel an der Unterseite des Adapters derart ausgebildet ist, dass es mit einem zur Montage eines Zusatzbauteils wie beispielsweise eines Hilfsschalters auf der Frontplatte eines elektrotechnischen Bauteils vorgesehenen Befestigungsmittel, insbesondere einer Einrastöffnung zusammenwirken kann. Dadurch kann der Adapter auf herkömmlichen elektrotechnischen Bauteilen wie Schaltgeräten, die zur Schaltschrankmontage vorgesehen sind und deren Frontplatte zur Montage von Zusatzbauteilen wie Hilfsschalter ausgebildet ist, beispielsweise anstelle eines Zusatzbauteils montiert werden.

Der Adapter kann insbesondere aus Kunststoff hergestellt sein. Insbesondere kann der Adapter als Kunststoff-Spritzgussteil oder als Stanz- bzw. Stanz-Biege-Teil aus einem formbaren Material wie beispielsweise einem Blech ausgebildet sein, wodurch er mit relativ geringem technischen Aufwand hergestellt werden kann.

In Implementierungen des Adapters können seine Abmessungen in der Montageebene an die Frontplatte mindestens eines elektrotechnischen Bauteils derart angepasst sein, dass keine Teile des Adapters über die Frontplatte hinausragen. Dies ermöglicht es beispielsweise, mehrere Bauteile auf einer Tragschiene eines Schaltschranks unmittelbar nebeneinander zu montieren und auf den Frontplatten einer oder mehrerer dieser Bauteile jeweils einen Adapter zu montieren, so dass auf den entsprechenden Bauteilen weitere Bauteile montiert werden können. Auf der Tragschiene nebeneinander montierte Bauteile können ohne Behinderungen durch montierte Adapter entfernt werden, ebenso können Bauteile auf der Tragschiene montiert werden.

Ferner wird ein elektrotechnisches Bauteil offenbart, das zur Montage an einer standardisierten Tragschiene ausgebildet ist und an seiner Frontplatte mindestens eine Einrastöffnung, mindestens eine Einschnappöffnung und/oder mindestens eine Gewindeöffnung zum Einrasten bzw. Einschnappen bzw. Einschrauben mindestens eines Einrasthakens bzw. Schnapphakens bzw. mindestens einer Schraube eines Adapters gemäß dem ersten Aspekt und wie hierin beschrieben aufweist.

Ein zweiter Aspekt betrifft eine gestapelte Anordnung von zwei elektrotechnischen Bauteilen, bei der auf der Frontplatte eines ersten Bauteils der Anordnung ein Adapter gemäß dem ersten Aspekt und wie hierin beschrieben und ein zweites Bauteil mit Befestigungsmitteln an seiner Unterseite an den Befestigungsmitteln auf der Oberseite des Adapters montiert ist.

Weitere Merkmale ergeben sich aus der nachfolgenden Beschreibung in Verbindung mit den in den Zeichnungen dargestellten Ausführungsbeispielen.

### Die Zeichnungen zeigen in

Fig. 1 ein Ausführungsbeispiel einer gestapelten Anordnung von zwei Schaltgeräten und verbunden durch ein Ausführungsbespiel eines Hutschienen-Adapters;
Fig. 2 das untere Schaltgerät der Anordnung von Fig. 1 mit dem auf seiner Frontplatte montierten Hutschienen-Adapter;
Fig. 3 ein weiteres Ausführungsbeispiel des Hutschienen-Adapters in einer Ansicht von unten und zwei Schnittansichten; und
Fig. 4 und 5 den Hutschienen-Adapter von Fig. 3 in einer Ansicht von schräg oben und schräg unten.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht einschränkend zu verstehen.

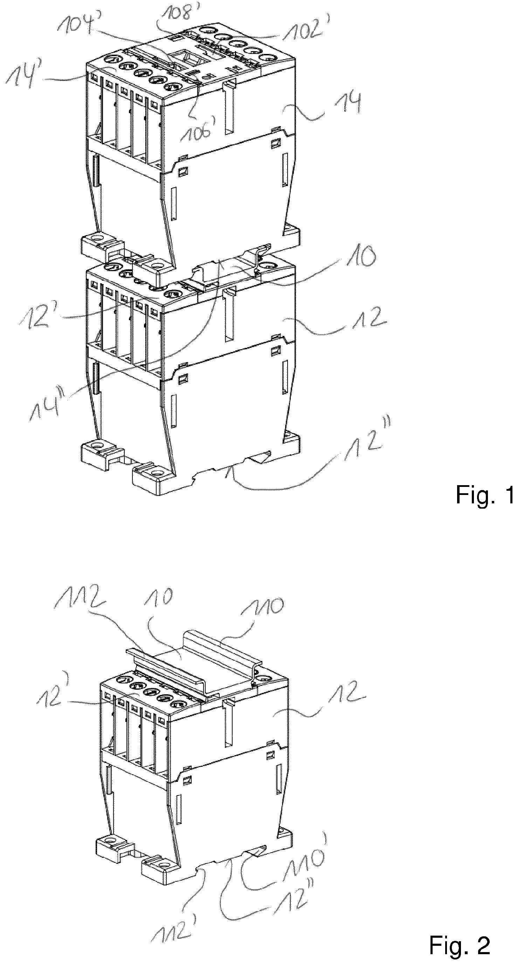

Fig. 1 zeigt eine Stapel-Anordnung eines ersten und eines zweiten Schaltgeräts 12 bzw. 14. Die Unterseiten 12", 14" der Schaltgeräte 12 bzw. 14 sind jeweils zur Montage des Schaltgeräts 12 bzw. 14 an einer Hutschiene ausgebildet. Die den Unterseiten 12", 14' gegenüberliegenden Frontplatten 12' bzw. 14' sind zur Montage eines Hutschienen-Adapters 10 ausgebildet und weisen hierzu entsprechende Öffnungen auf, die in Fig. 1 in der Frontplatte 14' zu erkennen sind. Bei den Öffnungen handelt es sich um zwei nebeneinander angeordnete Einrastöffnungen 102', 104' und zwei etwa diametral gegenüberliegend angeordneten Einschnappöffnungen 106', 108'. Die Öffnungen können beispielsweise dazu vorgesehen sein, ein Zusatzbauteil wie einen Hilfsschalter auf der Frontplatte zu montieren, d.h. sie müssen nicht speziell für die Montage des Hutschienen-Adapters in der Frontplatte vorgesehen werden, obwohl dies natürlich ebenso möglich ist. In diese Öffnungen können entsprechende Einrasthaken bzw. Schnapphaken einrasten bzw. einschnappen, welche den Hutschienen-Adapter 10 auf der Frontplatte 12' des Schaltgeräts 12 derart fixieren, dass der Adapter 10 nicht von der Fronplatte 12' abfallen und auf der Frontplatte 12' verrutschen kann. Zusätzlich kann der Hutschienen-Adapter 10 auf der Frontplatte 12' durch eine Schraubverbindung befestigt werden. Hierzu kann beispielsweise eine oder mehrere Schrauben durch entsprechende Öffnungen des Adapters geführt sein und in Gewindeöffnungen der Frontplatte des Schaltgeräts eingeschraubt werden.

Die Stapel-Anordnung der beiden Schaltgeräte 12 und 14 kann beispielsweise platzsparend in einem Schaltschrank auf einer darin vorgesehenen Hutschiene montiert werden, indem das untere Schaltgerät 12 mit seiner Unterseite 12" auf die Schaltschrank-Hutschiene aufgesteckt und beispielsweise an dieser angeklemmt wird. Die Montage der Stapel-Anordnung kann auf verschiedene Arten erfolgen: zunächst kann das untere Schaltgerät 12 an der Schaltschrank-Hutschiene montiert werden, dann der Hutschienen-Adapter 10 auf dem montierten Schaltgerät 12 und zuletzt das obere Schaltgerät 14 auf dem Adapter 10. Der Vorteil dieser Montageart besteht darin, dass beispielsweise nach der Montage des unteren Schaltgeräts 12 dieses verdrahtet werden kann, bevor mit der Montage des Adapters 10 und zweiten Schaltgeräts 14 fortgefahren wird. Alternativ kann die bereits vormontierte Stapel-Anordnung aus den Schaltgeräten 12 und 14 und dem Adapter 10 direkt an der Schaltschrank-Hutschiene montiert werden. Dies kann den Montageprozess verkürzen.

Fig. 2 zeigt das untere Schaltgerät 12 der Stapel-Anordnung von Fig. 1 mit dem auf der Fronplatte 12' montierten Hutschienen-Adapter 10. Die beiden Klemmschenkel 110, 112 auf der sichtbaren Oberseite des Adapters 10 werden zur Montage in entsprechende Aufnahmen auf der Unterseite 14" des oberen Schaltgeräts 14 wie bei der Hutschienen-Montage verklemmt, so dass eine sichere Befestigung der beiden Schaltgeräte 12 und 14 aneinander gewährleistet ist. In Fig. 2 sind die beiden entsprechenden Aufnahmen auf der Unterseite 12" des Schaltgeräts 12 mit den Bezugszeichen 110', 112' bezeichnet. In diese Aufnahmen können die Klemmschenkel beispielsweise einer Schaltschrank-Hutschiene oder eines weiteren Adapters eingeklemmt werden, zum Beispiel bei einer Stapel-Anordnung von drei Schaltgeräten.

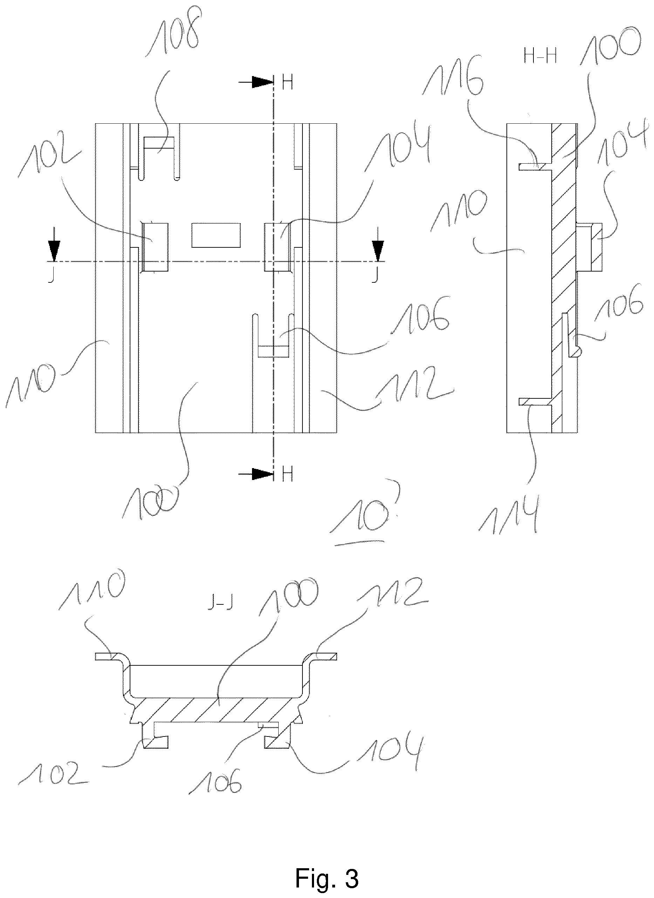

Fig. 3 zeigt verschiedene Ansichten eines weiteren Ausführungsbeispiels eines Hutschienen-Adapters 10` im Detail. Der Adapter 10` erfüllt im Wesentlichen dieselbe Funktion wie der Adapter 10 der Fig. 1 und 2.

Die Ansicht links oben in Fig. 3 zeigt die Unterseite des Adapters 10', der eine Grundplatte 100 und zwei jeweils an den Längsseiten der Grundplatte 100 gegenüberliegend angeordnete Klemmschenkel 110, 112 aufweist. An der Adapter-Unterseite sind ferner auf der Grundplatte 100 etwa symmetrisch zur Längsachse der Grundplatte 100 zwei Einrasthaken 102, 104 angeordnet. Zusätzlich sind asymmetrisch zur Längsachse zwei Schnapphaken 106, 108 angeordnet.

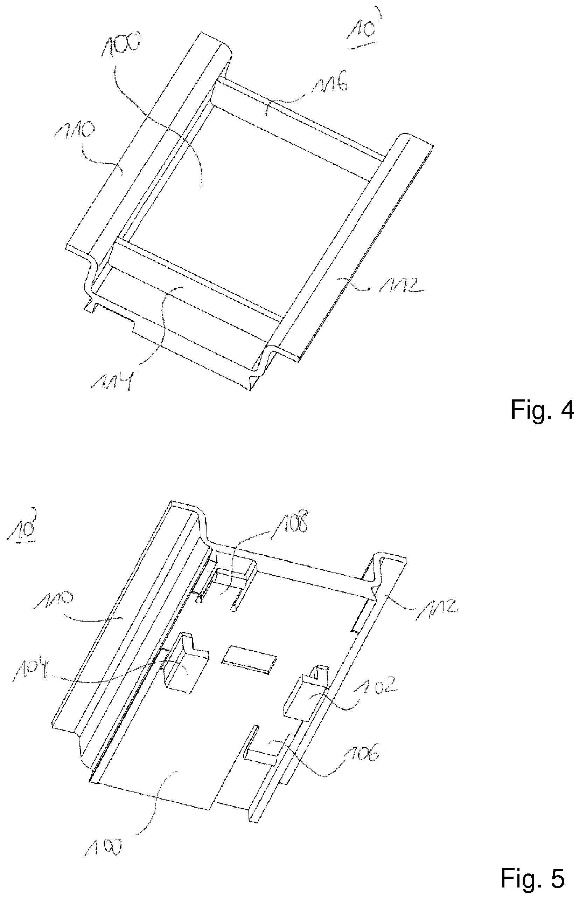

Die Form der Einrasthaken 102, 104 ist in den Schnittansichten entlang der Linien H-H und J-J in den Ansichten rechts oben und unten und in Fig. 5 gezeigt, welche die Unterseite des Adapters 10` in einer perspektivischen Ansicht zeigt. Die Einrasthaken 102, 104 sind dazu vorgesehen, in entsprechende Öffnungen 102', 104' (Fig. 1) auf der Frontplatte 14` (Fig. 1) eines Schaltgeräts 14 (Fig. 1) einzugreifen und in diese durch Verschieben des Adapters 10` in der Montageebene so einzurasten, dass der Adapter 10` nicht ohne Verschieben vom Schaltgerät abfallen kann.

Die Schnapphaken 106, 108 sind in Form von Zungen mit Vorsprüngen an ihren freien Enden ausgebildet. Die Vorsprünge sind zum Eingreifen bzw. Einschnappen in entsprechende schlitzförmige Einschnappöffnungen 106', 108` (Fig. 1) auf der Frontplatte 14` (Fig. 1) eines Schaltgeräts 14 (Fig. 1) ausgebildet. Hierbei sind die Schnapphaken 106, 108 so angeordnet und ausgebildet, dass die Vorsprünge nach dem Einrasten der Einrasthaken 102, 104, wenn der Adapter 10' verschoben wurde, sich etwa über den dafür vorgesehenen Einschnappöffnungen 106', 108' befinden und in diese einschnappen können. Durch die zungenförmige Ausbildung der Schnapphaken 106, 108 können diese bei entsprechender Materialauswahl wie Federn wirken, welche die Vorsprünge in die Einschnappöffnungen 106', 108' hineindrücken, wodurch ein Verrutschen des Adapters 10` auf der Frontplatte im montierten Zustand, d.h. nachdem alles eingerastet und eingeschnappt ist, effizient vermieden werden kann. Ein Lösen der Verbindung zwischen Adapter 10' und Frontplatte erfordert dann die Überwindung der Federkräfte der Schnapphaken 106, 108 und das entsprechende Verschieben des Adapters 10', damit die Einrasthaken 102, 104 aus ihrer Verrastung gelöst werden können.

In Fig. 4 ist der Adapter 10` in einer perspektivischen Ansicht von schräg oben gezeigt. Zwischen den an den beiden Längsseiten der Grundplatte 100 angeordneten Klemmschenkel 110, 112 können sich zwei Vorsprünge 114, 116 in Form von Zwischenwänden erstrecken. Diese Vorsprünge 114, 116 können beispielsweise eine Sicherung gegen ein Verrutschen eines auf der Oberseite des Adapters 10` montierten Bauteils bilden und/oder als Montagehilfe zum Ausrichten eines zu montierenden Bauteils dienen. Sie können auch die Stabilität des Adapters 10` verbessern, da sie Querstreben bilden, wodurch ein Verwinden des Adapters 10` verhindern können. Durch die Stabilisierung kann die Materialstärke der Grundplatte 100 unter Umständen reduziert werden, wodurch bei einer Stapel-Anordnung Platz eingespart werden kann.

Der Adapter 10, 10' kann einstückig aus einem Material hergestellt sein, welches insbesondere eine ausreichende Festigkeit und Federstärke für die Schnapphaken aufweisen kann. Ein besonders geeignetes Material ist Kunststoff mit einer ausreichenden Federsteifigkeit. Der Adapter kann auch als Stanzteil ausgebildet sein beispielsweise aus einem Federstahl.

## Patentansprüche

1. Adapter (10; 10') zur Montage elektrotechnischer Bauteile (12, 14), der in Form einer standardisierten Tragschiene, insbesondere Hutschiene, ausgebildet ist, und der an seiner Oberseite Befestigungsmittel (110, 112) zur Montage eines elektrotechnischen Bauteils und an seiner Unterseite Befestigungsmittel (102, 104, 106, 108) zur Montage auf der Frontplatte (12', 14') eines elektrotechnischen Bauteils (12, 14) aufweist, wobei die Befestigungsmittel an der Unterseite des Adapters mindestens einen Einrasthaken (102, 104) aufweisen, der zum Einrasten in eine entsprechende Einrastöffnung (102', 104') auf der Frontplatte (14') des elektrotechnischen Bauteils (14) ausgebildet ist, **dadurch gekennzeichnet, dass** die Befestigungsmittel an der Unterseite des Adapters mindestens einen Schnapphaken (106, 108) aufweisen, der zum Einschnappen in eine entsprechende Einschnappöffnung (106', 108') auf der Frontplatte (14') des elektrotechnischen Bauteils (14) ausgebildet ist, wobei die Befestigungsmittel geeignet sind den Adapter (10, 10') auf der Frontplatte (12', 14') des elektrotechnischen Bauteils (12, 14) derart zu fixieren, dass der Adapter (10, 10') nicht auf der Frontplatte (14') verrutschen kann.

2. Adapter nach Anspruch 1, **dadurch gekennzeichnet, dass** mindestens ein Vorsprung (114, 116) auf der Oberseite des Adapters (10') vorgesehen ist.

3. Adapter nach einem der vorhergehenden Ansprüche, **dadurch gekennzeichnet, dass** die Befestigungsmittel an der Unterseite des Adapters mindestens eine Schraube aufweisen, die in eine entsprechende Gewindeöffnung auf der Frontplatte (12', 14') eines elektrotechnischen Bauteils (12, 14) eingeschraubt werden kann.

4. Adapter nach einem der vorhergehenden Ansprüche, **dadurch gekennzeichnet, dass** die Befestigungsmittel an der Oberseite des Adapters mindestens ein Gewinde aufweisen, in das eine an der Unterseite eines elektrotechnischen Bauteils (12, 14) vorgesehene Schraube eingeschraubt werden kann.

5. Adapter nach einem der vorhergehenden Ansprüche, **dadurch gekennzeichnet, dass** zumindest eines der Befestigungsmittel (102, 104, 106, 108) an der Unterseite des Adapters (10; 10') derart ausgebildet ist, dass es mit einer Einrastöffnung (102', 104') zusammenwirken kann, die zur Montage eines Zusatzbauteils auf der Frontplatte (12', 14') eines elektrotechnischen Bauteils (12, 14) vorgesehen ist.

6. Adapter nach einem der vorhergehenden Ansprüche, **dadurch gekennzeichnet, dass** er aus Kunststoff hergestellt ist.

7. Adapter nach einem der vorhergehenden Ansprüche, **dadurch gekennzeichnet, dass** seine Abmessungen in der Montageebene an die Frontplatte (12', 14') mindestens eines elektrotechnischen Bauteils (12, 14) derart angepasst sind, dass keine Teile des Adapters über die Frontplatte(n) hinausragen.

8. Gestapelte Anordnung von zwei elektrotechnischen Bauteilen (12, 14), bei der auf der Frontplatte eines ersten Bauteils (12) der Anordnung ein Adapter (10) nach einem der Ansprüche 1 bis 7 und ein zweites Bauteil (14) mit Befestigungsmitteln an seiner Unterseite an den Befestigungsmitteln auf der Oberseite des Adapters (10) montiert ist.

## Claims

1. An adapter (10; 10') for mounting of electrotechnical components (12, 14) which is formed in the form of a standardized support rail, in particular DIN rail, and which, on its upper side, has fastening means (110, 112) for mounting of an electrotechnical component and, on its underside, has fastening means (102, 104, 106, 108) for mounting on the front plate (12', 14') of an electrotechnical component (12, 14), wherein the fastening means on the underside of the adapter have at least one detent hook (102, 104), which is designed to latch into a corresponding detent opening (102', 104') on the front plate (14') of the electrotechnical component (14), **characterized in that** the fastening means on the underside of the adapter have at least one snap-in hook (106, 108), which is designed to snap into a corresponding snap-in opening (106', 108') on the front plate (14') of the electrotechnical component (14), wherein the fastening means are suitable for fixing the adapter (10, 10') on the front plate (12', 14') of the electrotechnical component (12, 14) in such a way that the adapter (10, 10') cannot shift on the front plate (14').

2. The adapter according to claim 1, **characterized in that** at least one protrusion (114, 116) is provided on the upper side of the adapter (10').

3. The adapter according to any one of the preceding claims, **characterized in that** the fastening means on the underside of the adapter have at least one screw, which can be screwed into a corresponding threaded opening on the front plate (12', 14') of an electrotechnical component (12, 14).

4. The adapter according to any one of the preceding claims, **characterized in that** the fastening means on the upper side of the adapter have at least one thread, into which the screw provided on the underside of an electrotechnical component (12, 14) can be screwed.

5. The adapter according to any one of the preceding claims, **characterized in that** at least one of the fastening means (102, 104, 106, 108) on the underside of the adapter (10; 10') is designed in such a way that it can cooperate with a detent opening (102', 104') which is provided for mounting of an add-on component on the front plate (12', 14') of an electrotechnical component (12, 14).

6. The adapter according to any one of the preceding claims, **characterized in that** it is made of plastic.

7. The adapter according to any one of the preceding claims, **characterized in that** its dimensions in the mounting plane are adapted to the front plate (12', 14') of at least one electrotechnical component (12, 14) in such a way that no parts of the adapter protrude beyond the front plate(s).

8. A stacked arrangement of two electrotechnical components (12, 14), in which an adapter (10) according to any one of claims 1 to 7 is mounted on the front plate of a first component (12) of the arrangement and a second component (14) with fastening means on its underside is mounted to the fastening means on the upper side of the adapter (10).

## Revendications

1. Adaptateur (10 ; 10') de montage de composants électrotechniques (12, 14) qui est réalisé sous la forme d'un rail DIN, en particulier d'un profilé chapeau, et qui présente, sur sa face supérieure, des moyens de fixation (110, 112) pour le montage d'un composant électrotechnique et, sur sa face inférieure, des moyens de fixation (102, 104, 106, 108) pour le montage sur la plaque frontale (12', 14') d'un composant électrotechnique (12, 14), les moyens de fixation présentant, sur la face inférieure de l'adaptateur, au moins un crochet d'encliquetage (102, 104) qui est conçu pour s'encliqueter dans une ouverture d'encliquetage correspondante (102', 104') sur la plaque frontale (14') du composant électrotechnique (14), **caractérisé en ce que** les moyens de fixation présentent, sur la face inférieure de l'adaptateur, au moins un crochet à déclic (106, 108), qui est conçu pour s'encliqueter dans une ouverture d'encliquetage correspondante (106', 108') sur la plaque frontale (14') du composant électrotechnique (14), les moyens de fixation étant adaptés à fixer l'adaptateur (10, 10') sur la plaque frontale (12', 14') du composant électrotechnique (12, 14) de façon que l'adaptateur (10, 10') ne puisse pas glisser sur la plaque frontale (14').

2. Adaptateur selon la revendication 1, **caractérisé en ce qu'**au moins une saillie (114, 116) est disposée sur la face supérieure de l'adaptateur (10').

3. Adaptateur selon l'une quelconque des revendications précédentes, **caractérisé en ce que** les moyens de fixation, sur la face inférieure de l'adaptateur, présentent au moins une vis qui peut être vissée dans une ouverture filetée correspondante sur la plaque frontale (12', 14') d'un composant électrotechnique (12, 14).

4. Adaptateur selon l'une quelconque des revendications précédentes, **caractérisé en ce que** les moyens de fixation, sur la face supérieure de l'adaptateur, présentent au moins un filet dans lequel peut être vissée une vis disposée sur la face inférieure d'un composant électrotechnique (12, 14).

5. Adaptateur selon l'une quelconque des revendications précédentes, **caractérisé en ce qu'**au moins l'un des moyens de fixation (102, 104, 106, 108) sur la face inférieure de l'adaptateur (10 ; 10') est conçu de manière à pouvoir coopérer avec une ouverture d'encliquetage (102', 104') qui sert au montage d'un composant supplémentaire sur la plaque frontale (12', 14') d'un composant électrotechnique (12, 14).

6. Adaptateur selon l'une quelconque des revendications précédentes, **caractérisé en ce qu'**il est fabriqué en matière plastique.

7. Adaptateur selon l'une quelconques des revendications précédentes, **caractérisé en ce que** ses dimensions dans le plan de montage sont adaptées à la plaque frontale (12', 14') d'au moins un composant électrotechnique (12, 14), de façon qu'aucune partie de l'adaptateur ne dépasse de la ou des plaques frontales.

8. Ensemble empilé de deux composants électrotechniques (12, 14), dans lequel un adaptateur (10) selon l'une des revendications 1 à 7, est monté sur la plaque frontale d'un premier composant (12) de l'ensemble et un second composant (14) comprenant des moyens de fixation sur sa face inférieure est monté sur les moyens de fixation sur la face supérieure de l'adaptateur (10).
